# EUROPEAN PATENT APPLICATION

(11) **EP 1 627 935 A1**
(43) Date of publication of application: **22.02.2006**
(21) Application number: 04733458.6
(22) Date of filing: 17.05.2004
(51) Int. Cl.: C23C 22/03, H05K 3/34, H05K 3/28, H01L 23/12, B23K 35/22, B23K 35/26, B23K 35/363

(54) **SURFACE TREATING AGENT FOR TIN OR TIN ALLOY MATERIAL**

(30) Priority: 16.05.2003 JP 2003139017
(71) Applicant: SONY CORPORATION, Tokyo 141-0001 (JP); TARUTIN KESTER CO., LTD., Sumida-ku, Tokyo 1300003 (JP); Nikko Materials Company, Limited, Tokyo 105-0001 (JP)
(72) Inventor: MASATOKI, Tamiharu, c/o Sony Corporation, Shinagawa-ku, Tokyo 1410001 (JP); TSURUSAKI, Arata, Sony Human Capital Corporation, Shinagawa-ku, Tokyo 1410001 (JP); KUMAGAI, Masashi, Nikko Materials Co., Ltd., Kitaibaraki-shi, Ibaraki 3191535 (JP); OUCHI, Takashi, Nikko Materials Co., Ltd., Kitaibaraki-shi, Ibaraki 3191535 (JP); KINASE, Takashi, Nikko Metal Plating Co., Ltd., Takatsuki-shi, Osaka 5690036 (JP); SUGIOKA, Masataka, c/o Tarutin Kester Co., Ltd., Narita-shi, Chiba 2860825 (JP); NAKANO, Takeshi, c/o Tarutin Kester Co., Ltd., Narita-shi, Chiba 2860825 (JP)
(74) Representative: Leppard, Andrew John
(86) International application number: PCT/JP2004/006972
(87) International publication number: WO 2004/101849

(57) **Abstract**

There is disclosed is a method comprising surface-processing a Sn based, Sn alloy based or Sn-Zn alloy based solder particle (1), applied as a coating, such as by electrical plating or melt plating, to the surface of a metal material, such as iron, a steel plate or copper, with a phosphate and a silicium containing compound, to form a protective film (2). There are also disclosed a solder material (6) in which a protective film (2) formed of a phosphate and a silicium containing compound is formed on the surface of the Sn-Zn based solder particle (1), and a solder paste formed of this solder material (6) and the flux.

## Description

### Technical Field

This invention relates to a surface processing agent for tin or a tin alloy material, tin or tin alloy material, a method for surface processing therefor, a tin alloy based solder material, a solder paste employing this solder material, a method for the preparation of a tin alloy based solder material, an electronic device, a printed circuit board, and to a mount structure of the electronic device.

The present invention contains subject matter related to Japanese Patent Application JP2003-139017 filed in the Japanese Patent Office on May 16, 2003, the entire contents of which are incorporated herein by reference.

### Background Art

In soldering (reflow soldering) a surface mount device (sometimes referred to below as SMD) or an insert mount device, which is a device fitted with a lead terminal (sometimes referred to below as IMD), to a printed circuit board in a reflow furnace, a Sn (tin)- Pb (lead) solder, or a solder paste containing particles of this solder, has so far been used. The Sn-Pb solder has a long history of use and is an excellent material in point of a soldering temperature (melting point of the solder), solderability (wetting ability), quality and reliability of soldered products and soldering workability.

Recently, for combating environmental pollution, a demand has been raised for a lead-free solder which should take the place of Sn-Pb solder. However, it is thought to be difficult to develop a material which in all aspects surpasses the Sn-Pb solder.

Up to now, a substitute material for the Sn-Pb solder has energetically been researched, and a Sn (tin)- Ag (silver)- Cu (copper)- Bi (bismuth)- Ge (germanium) material of a quinary system (five component type), a Sn- Ag-Cu- Bi material of a quaternary system (four component type), and Sn- Ag- Bi, Sn- Ag- Cu or and Sn- Cu- (Ni) material of a ternary system, where (Ni) (nickel) means a trace additive, hereinafter the same, have so far been publicized.

Of these, Sn- Cu- (Ni) or Sn- Ag- Cu is thought to be promising as a material for linear tar-doped solder used for manual soldering (or soldering by a robot) or for bar-like (or ingot-like) solder used for flow soldering.

These soldering materials melt at a temperature higher than in the case of the Sn- Pb eutectic solder (217°C or higher). However, in reflow soldering, employing a solder paste, a high melting point of the solder gives rise to a variety of problems, as indicated below in (1) to (3):
(1) Since the working temperature for soldering is high, the temperature distribution (ΔT) and the temperature margin (tolerance) of a printed circuit substrate (e.g. 245 by 128 mm) are lowered, such that soldering failure is liable to be produced (this effect is outstanding especially in a low temperature area).
(2) For successfully coping with this deficiency, it becomes necessary to develop a reflow furnace having a large thermal capacity and superior temperature uniformity by way of equipment investment. However, the conventional equipment becomes unnecessary and has to be discarded.
(3) Moreover, should there be any devices having insufficient thermal resistance, such as electrolytic capacitor, certain types of connectors or thin ICs, excessively heated portions thereof are affected severely, whilst the energy (power) consumption is increased, thus raising the product cost. In addition, the quality as well as reliability (product quality and useful life) is degraded to lower the value/price (ROI).

Under the current status of the art, no practically useful reflow solder material (for solder paste), capable of overcoming these problems, has so far been developed. Although the Sn (tin)- Zn (zinc) based solder material is thought to be promising, and has an advantage of melting at a lower temperature (190°C ~) which is close to the melting point (183°C) of the Sn-Pb material (eutectic material), this solder material has the following defects:

In a well-known manner, zinc (Zn) is a highly active material and exhibits strong reactivity. For this reason, Sn-Zn also exhibits strong reactivity which is deterrent to reflow solderability. Generally, Sn- Zn has the following deficiencies (1) and (ii):

### (i) Instability of solder paste

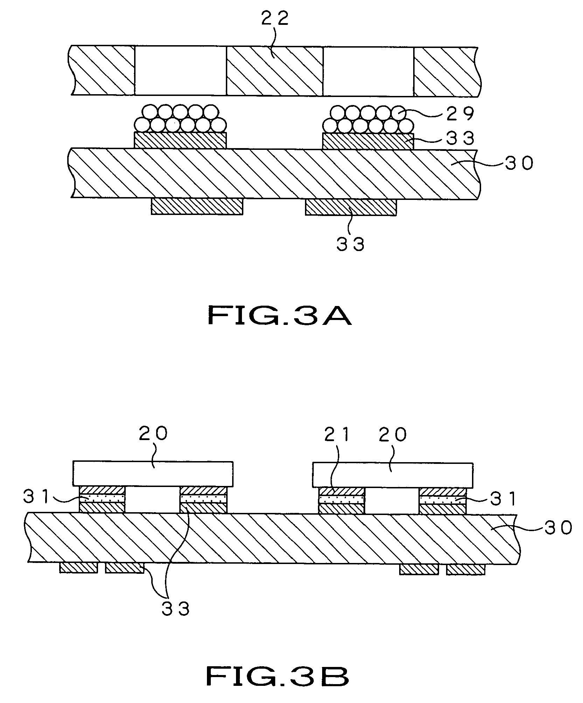

Zn is reacted with various components in the solder paste or with the moisture as well as oxygen in air and degraded (transmuted) to undergo changes in viscosity. Consequently, the material lacks in stability in pot life (preservation time), repetitive printability or in shelf life (time until an electronic device, such as SMD, is mounted following coating or screen printing), with the result that such problems as dislocation of electronic devices due to lowered tack force is liable to be produced. As for the repetitive printability, reference is made to the explanation which will be made subsequently in connection with Fig.3(a).

### (ii) Oxidation during reflow soldering

When soldering a printed circuit board, having SMDs or IMDs mounted thereon, through a reflow furnace, Zn is oxidized to generate solder balls or wetting (soldering) failure. For combating this, a nitrogen (N₂) reflow furnace is used. For the reflow, referred to above, an air (hot air) reflow furnace is customarily used. The N₂ reflow furnace has a drawback that it needs a special device for N₂ generation, ventilation or oxygen (O₂) density control, and that the running cost is high.

One of the present inventors has already proposed a tin (Sn) or a Sn alloy, in which a surface protective film of Sn (tin) or gold (Au) is plated on a lead-free solder particle in a non-aqueous system or in a dry system to improve resistance against oxidation, resistance against corrosion and resistance against transmutation, and a method for the preparation of the surface protective film (claims, column 3 line 3 to column 6 line 28 and Fig.1 of JP Laid-Open Patent Publication 2002-331385).

There has also been proposed using a solder paste obtained on adding a reducing agent, comprising an organic acid ester, such as sulfonic acid ester, or a phosphrous acid ester, such as triphenyl phosphite, to a flux, and on mixing the resulting product to solder particles of e.g. Sn-Zn or Sn-Ag, to suppress the reaction of the solder particles with the flux to improve the pot life (see pamphlet of International Laid-Open Patent Publication 99-64199 page 13 lines 3 to 28 and page 14 lines 9 to 20).

The surface protective film, proposed in the JP Laid-Open Patent Publication 2002-331385, is able to confer superior resistance against oxidation, resistance against corrosion and resistance against transmutation to lead-free solder particles, such as Sn-Zn. However, since the surface protective film is formed in a dry system, such as by sputtering, on the surface of the solder particle, the film forming takes much time, in a manner deterrent to mass production, while the cost is high. In addition, it may become necessary to use special film-forming conditions, such as causing vibrations of the solder particles, with ultrasonic waves, for improving the film thickness uniformity.

On the other hand, mere addition of an organic acid ester or a reducing agent to the flux, as disclosed in the pamphlet of International Laid-Open Patent Publication 99-64199, is not effective to suppress sufficiently the reaction activity of the surface of the solder particle. In addition, since the repetitive printability is low, the rate of effective use of the solder paste is low (~80%) to cause loss and elevated cost.

### Disclosure of the Invention

It is therefore an object of the present invention to provide a reflowable, in particular air reflowable, low melting solder material, which, while making best use of the aforementioned features proper to the solder material, such as Sn-Zn based solder material, overcomes the deficiencies inherent in the solder material, and which, by processing with a surface processing agent, exhibits improved resistance against oxidation and against transmutation, as well as improved solderability, extremely readily and at low cost. The present invention is also aimed to provide Sn or an Sn alloy material used for the solder material, and a solder paste, extremely readily and at low cost.

Thus, the present invention provides a surface processing agent for tin or a tin alloy material essentially composed of a substance selected from the group consisting of at least one ester selected from the group consisting of a phosphate, a phosphite and derivative thereof, a silicium containing compound, and a reaction product and/or a mixture of the ester and the silicium containing compound.

The present invention also provides, as a surface processing method by the surface processing agent, a surface processing method for tin or a tin alloy material comprising coating the surface of tin or the tin alloy material, with a solution obtained on diluting the reaction product and/or the mixture with an organic solvent, and drying the resulting product, a method for the preparation of a tin alloy based solder material comprising applying this surface processing method to the surface of the tin alloy based solder particle, a surface processing method for tin or a tin alloy material comprising coating the surface of tin or a tin alloy based material with a solution obtained on diluting the ester with an organic solvent, drying the resulting product, depositing a solution, obtained on diluting the above ester with an organic solution, drying the resulting product, depositing a solution obtained on diluting the above silicium containing compound with an organic solvent on the resulting dried film, and drying the resulting product, a method for the preparation of a tin alloy based solder material comprising applying the surface processing method to the surface of the tin alloy based solder particle, a surface processing method for tin or the tin alloy material comprising coating the surface of the tin or the tin alloy material with a solution obtained on diluting the silicium containing compound with an organic solvent, drying the resulting product, depositing a solution obtained on diluting the ester with the organic solvent on the resulting dried film, and drying the resulting product, and a method for the preparation of a tin alloy based solder material comprising applying the surface processing method to the surface of the tin alloy based solder particle.

The present invention also provides tin or a tin alloy material having a surface protective film composed of at least one selected from the group consisting of the above ester, the above silicium containing compound and a reaction product thereof (referred to below as a surface protective film of the present invention), a tin alloy based solder material comprising a surface protective film of the present invention, composed of at least one selected from the group consisting of the above ester, the above silicium containing compound and a reaction product thereof, and a solder particle of a tin alloy based alloy, on the surface of which is formed the above surface protective film, and a solder paste comprising a solder particle formed of the solder material.

The present invention also provides an electronic device, a connecting terminal of which is composed of tin or the tin alloy material and which is provided with the surface protective film of the present invention, a mount structure for an electronic device, in which the electronic device is connected to a printed circuit board, an electronic device in which a solder ball as a tin alloy based solder material having the surface protective film of the present invention is used as an electrical connecting material, a mount structure for an electronic device, in which the electronic device is connected to a printed circuit board, a printed circuit board, an connecting terminal of which is formed of the above tin or the tin alloy material having the surface protective film of the present invention, a mount structure of an electronic device in which the electronic device is connected to the printed circuit board, and a mount structure of an electronic device, in which the above paste, containing the solder particles having the surface protective film of the present invention, is used as an electrical connecting material.

It is noted that the solder ball or the solder paste of the present invention may be used not only for mounting the electronic device to the printed circuit board but also for providing connection for stack mount of plural electronic devices.

It is also noted that the surface protective film of the present invention is desirable not only as a solder material or solder paste used for reflow soldering SMDs or IMDs, but also as a surface processing material (sometimes referred to below as a coating material) for a metal material, such as a surface coating layer for an electrode or a terminal (sometimes referred to below as an electrode) of an electronic device or an interconnect pattern (land or through-hole, sometimes referred to below as a land) for a printed circuit board.

According to the present invention, in which the surface protective film of the present invention is formed on the surface of Sn or a Sn alloy material, a solder material, formed of a Sn alloy, in particular, may effectively be blocked off from flux components, in particular an activating agent, and from the moisture or oxygen in air. The result is that it is possible to prevent transmutation or oxidation of Sn or the Sn alloy material, as well as to suppress deterioration in the solder wettability.

It is also possible to improve the pot life, repetitive printability and shelf life of the paste employing the Sn alloy powders and to maintain the tack force of the solder paste to an electronic device for mounting. During heating processing in a reflow furnace, solder particles may be prevented from being oxidized to eliminate soldering failure otherwise caused by failure in wetting, thereby enabling the use of a general-purpose system, such as air reflow system.

Moreover, the surface of the electrode (terminal) of an electronic device or an interconnect pattern (land) of a printed circuit board, formed by Sn or the Sn alloy material, and which is protected by the surface protective film of the present invention, is superior in resistance against oxidation, resistance against corrosion and in resistance against transmutation,

In particular, the solder material, formed by the surface-processed Sn-Zn based solder particles, remains stable even after it is formed into a solder paste, and hence the pot life, repetitive printability or shelf life thereof may be longer to render it possible to make practical use of lead-free low-melting solder paste.

In addition, since the surface protective film of the present invention may be endowed with a certain level of thermal resistance (not lower than 240°C), the solder material remains stable during reflow soldering, such that solderability (solder wetting ability) is optimum until the Sn-Zn based solder forms an alloy layer with the motherboard, such as the electrode or the land, the solder is to be joined to, while solder balls are generated only in a lesser quantity to enable the use of the air reflow furnace.

Consequently, the features of the Sn-Zn solder, having a low melting point (not higher than 200°C) and which may be used as a substitute material for Sn-Pb solder, may effectively be displayed to render possible soldering of high quality and reliability.

The surface protective film of the present invention is composed of at least one selected from the group consisting of at least one ester, selected from the group consisting of a phosphate, a phosphite and a derivative thereof, a silicium containing compound, and a reaction product thereof, and hence may be formed by contacting the aforementioned surface processing agent in a state of a solution with the surface of tin or the tin alloy material, and by drying the resulting product in situ. For film forming, no special conditions are needed, such that the film forming may be carried out easily at low costs. Since the surface processing agent may be affixed sufficiently and evenly to the surface of tin or the tin alloy material, film thickness uniformity may be improved readily.

The solder material and the coating material of the present invention are preferably formed in accordance with the manufacturing method of the present invention having a step of forming a surface protective film of the present invention on the surface of tin or the tin alloy material by non-aqueous surface processing. More preferably, surface processing (drying) is carried out in an inert gas atmosphere, such as in nitrogen (N₂) or argon (Ar), or in vacuum.

By forming the surface protective film of the present invention by surface processing in a non-aqueous solution (diluted with an organic solvent), and in an inert gas atmosphere or in vacuum, there is no risk of the Sn-Zn based alloy being transmuted by the reaction with water or with oxygen, in the course of the manufacture of the solder material or the coating material, with the result that the targeted solder material or coating material may be obtained reliably in stability.

Other objects and concrete advantages of the present invention will become more apparent from the following explanation of preferred embodiments thereof especially when read in conjunction with the drawings.

### Brief Description of the Drawings

Figs.1A and 1B are enlarged cross-sectional views showing two examples of a Sn-Zn based solder material fitted with a surface protective film according to the present invention.
Fig.2 is a diagram showing the manufacture flow (surface processing steps) of the above solder material.
Figs.3A and 3B are cross-sectional views showing an example of an SMD surface mount process employing the same solder material.
Fig.4 is a cross-sectional view of a surface mount example of an electronic device including a surface protective film formed on a tin plating of an outer lead.
Fig.5 is a cross-sectional view of a printed circuit board including a surface protective film formed on tin-zinc plating formed on a land.
Fig.6A is a cross-sectional view of a semiconductor package including a surface protective film formed on each of a plurality of solder balls making up a ball grid array and Fig.6B is a cross-sectional view showing the state in which the ball grid array is mounted on a printed circuit board.
Figs.7A and 7B are graphs showing a NMR spectrum of the components of the surface protective film.

### Best Mode for Carrying out the Invention

In the surface processing agent of the present invention, the reaction product and/or the mixture, described above, is preferably diluted with an organic solvent. The ratio of the above ester and the silicium compound is preferably 1: 10 to 10: 1 in terms of a molar ratio.

The phosphate, phosphite and the derivative, described above, preferably are each provided with at least one saturated or unsaturated alkyl group and/or a hydroxyl group, while the silicium containing compound preferably includes at least one alkoxy silyl group and/or a silano group.

The tin alloy material or the tin alloy material based solder particle is preferably a tin alloy material or the tin alloy based solder particle containing at least one metal selected from the group consisting of zinc, bismuth, copper, silver, antimony, indium, aluminum, magnesium, germanium and nickel.

In particular, as a Sn-Zn based alloy, an alloy essentially composed of Sn, such as Sn- Zn- Bi (0.5 to 10 parts by weight of Zn, 0.5 to 8 parts by weight of Bi, with the balance being Sn), may be used, to say nothing of Sn-Zn (0.5 to 10 parts by weight of Zn, with the balance being Sn). The solder particle of the solder paste is usually of the diameter of 20 to 60 µm. Although the solder particle may be spherically-shaped or amorphous, it is preferably spherically-shaped by granulation based on the atomizing method.

The surface protective film of the present invention, formed on the surface of the solder particle, is preferably formed of a stable material exhibiting superior solderability and resistance against oxidation (outside air blocking performance) and which is not susceptible to isolation or ionization when left over after soldering. The surface protective film is preferably of such a material that may be unified with the Sn- Zn solder during reflow soldering or may promote wetting. Or, the surface protective film may also be of such a material that may be decomposed or dissolved and discharged to outside the system or may become diffused into the solder.

The surface protective film of the present invention is preferably of a thickness on the order of 0.002 to 2µm in view of (ease of) manufacture and for accomplishing the object of the present invention. Although a single layer surface protective film of the present invention suffices, the surface protective film may also comprise plural layers. In case the first thin film, formed by the ester, the second thin film, formed by the silicium containing compound, or the thin film of the reaction product, combination therewith, make up the above surface protective film, the first thin film is preferably formed in contact with the surface of the tin or the tin alloy material.

The surface protective film of the present invention is preferably formed on the surface of the solder particles for the solder paste or on the surface of the solder balls, these electrical connecting materials may be used as terminals, e.g. electrodes, of electronic devices, lands or as a ball grid array.

The solder paste may contain a flux, composed of polymerized rosin, hydrogenated rosin, a solvent, an activating agent and a thixo agent, in addition to the aforementioned solder particles including the surface protective film of the present invention.

Referring to the drawings, preferred embodiments of the present invention will be explained hereinbelow in more detail.

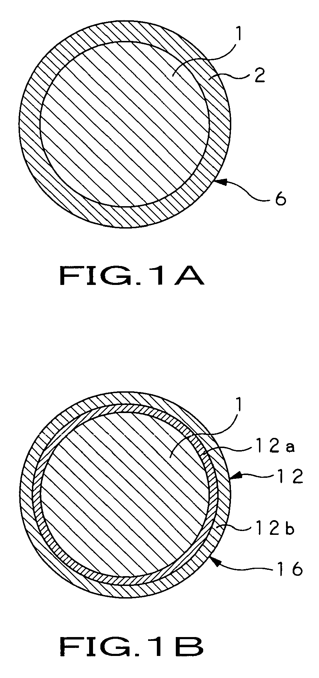

Fig.1A shows an example 6 of a solder material according to the present invention. It may be seen that an outer surface of a Sn-Zn based solder particle 1 is coated with a single-layer surface protective film 2 by the surface processing method of the present invention.

Fig.1B shows another example 16 of a solder material according to the present invention. It may be seen that an outer surface of a Sn-Zn based solder particle 1 is coated with a surface protective film 12, comprising a first surface protective film 12a and a second surface protective film 12b, layered thereon, by a surface processing method according to the present invention.

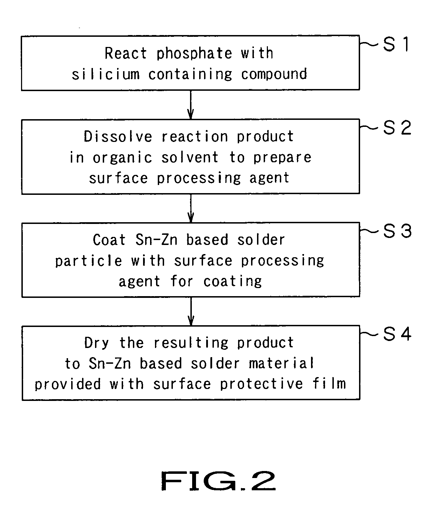

Fig.2 shows a typical manufacture flow of such Sn-Zn based solder material, having such surface protective film formed thereon.

For preparing the solder material of Fig.1A, a phosphoric acid ester and a silicium-containing compound are reacted together (step S1 of Fig.2) and the resultant reaction product is diluted with an organic solvent to prepare a solution of a surface processing agent (step S2 of Fig.2). The Sn-Zn based solder particle is immersed and dispersed in this solution (step S3 of Fig.2). The solder particle, thus surface-processed (that is, having its surface coated with a surface processing agent), is separated from the solution and dried to yield a solder material provided with a surface protective film (step S4 of Fig.2).

For preparing the solder material of Fig.1B, the above-described surface processing process is carried out in two stages. That is, the Sn-Zn based solder particle has its surface coated with a solution obtained on diluting a phosphate with an organic solvent and subsequently dried. On the resultant dried film is deposited a solution obtained on diluting the silicium-containing compound with the organic solvent, and the resultant assembly is dried. Or, the Sn-Zn based solder particle has its surface coated with a solution obtained on diluting a phosphoric acid ester with an organic solvent and subsequently dried, and a solution obtained on diluting a phosphate with an organic solvent is deposited on the resultant dried film. The resultant assembly is then dried.

Figs.3A and 3B show a typical process for preparing a solder paste using the solder material provided with the surface protective film, obtained as described above (reflow soldering). In these figures, there is shown an example of single-sided mounting in which an adhesive for chip devices is not shown.

Referring to Fig.3A, a solder paste 29, composed of a rosin-based flux, inclusive of a solvent, and e.g. a modified resin thereof, are transcribed (printed) on a interconnection pattern (land) 33 of a printed circuit board 30, along with a solder material 6, described above, by a printing method employing a metal mask (screen) 22.

Then, a plural number of SMDs 20, such as chip resistors or chip size packages (CSPs) are mounted thereon, and the solder paste 29 is melted by reflow (melting by heating) in an air reflow furnace, by way of effecting the soldering (reflow soldering), as shown in Fig.3B. That is, the SMD 20 is mounted by joining its electrode 21 to a land 33 on the printed circuit board 30, with a solder 31 obtained on heating and fusing the solder paste 29, as shown in Fig.3B.

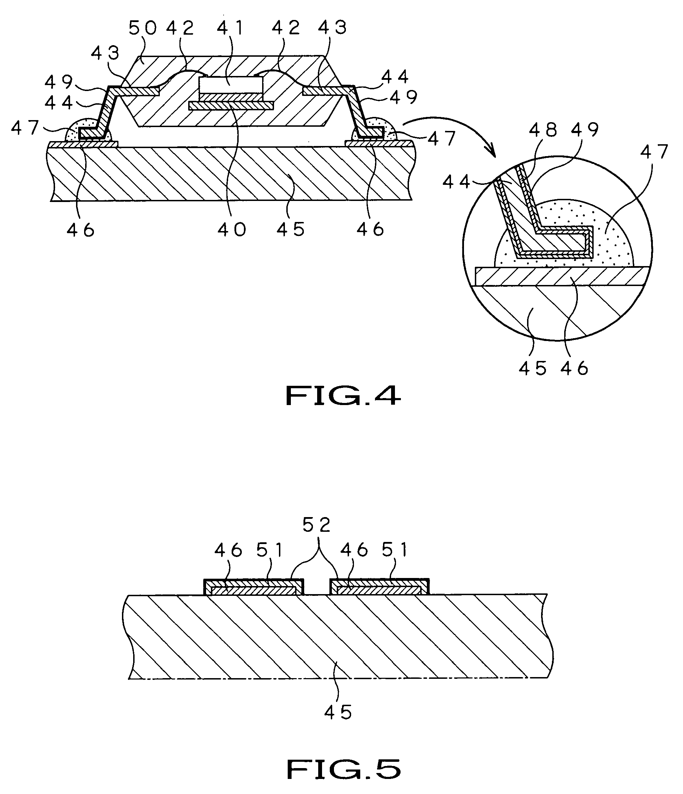

Fig.4 shows a case of mounting an electronic device, fitted with an outer lead. In this case, an electrode pad of a semiconductor integrated circuit chip 41, mounted on a die pad 40, is bonded with a wire 42 to an inner lead 43 and encapsulated in a molded resin 50 to form a package, which package then is connected with a solder 47 to a land 46 of a printed circuit board 45 to form a mount structure. A tin plating 48 is applied, as a coating layer, on the surface of a lead frame inclusive of an outer lead 44 of Cu. It is noted that, of the surface of the tin plating 48, the surface of the outer lead 44 is coated with a surface protective film 49 embodying the present invention.

By coating the tin plating or the tin alloy material plating 48 of the outer lead 44 with the surface protective film 49, it is possible to provide for optimum wetting performance of the solder 47, while it is also possible to prevent oxidation or corrosion of the tin or tin alloy material or whisker formation to suppress the deterioration of soldering performance of the outer lead 44 or to suppress the risk of shorting otherwise brought about by whiskers. Meanwhile, if the solder of the solder paste, inclusive of the aforementioned Sn-Zn based solder material 6, provided with the surface protective film 2, is used as the solder 47, it is naturally possible to improve oxidation resistance of the solder itself.

It should be noted that the present invention may be applied to a so-called multi-dispenser soldering system (MDS), as a process for post-fitting of an IMD, to join a terminal of the IMD to the land with a solder, by melting on heating of the solder paste, although this embodiment of the present invention is not shown. In this case, it is possible to coat the tin plating or the tin alloy plating on the surface of the IMD terminal with the aforementioned surface protective film or to use a solder paste inclusive of the Sn-Zn based solder material provided with the surface protective film as described above.

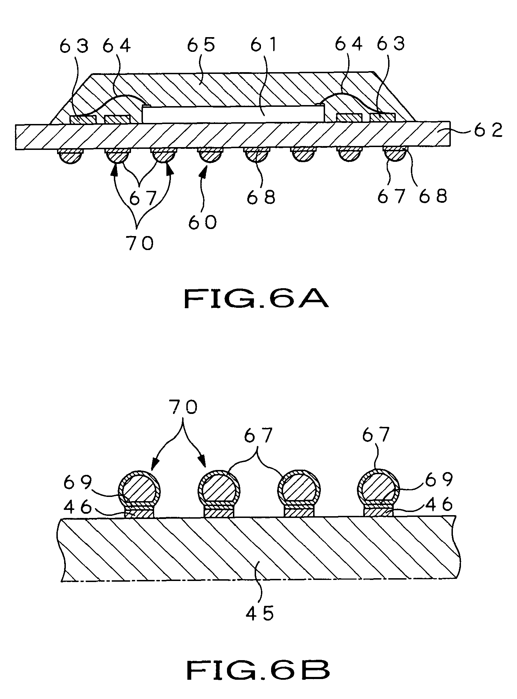

Fig.5 shows a case in which, when a tin plating or a tin alloy plating 51 is applied as a coating layer to a land 46 of the printed circuit board 45, this tin plating or tin alloy material plating 51 is coated with a surface protective film 52 embodying the present invention.

In such case, the wetting performance of the solder with respect to the land 46 may be optimized, while the tin plating or tin alloy plating 51 of the land 46 may be prevented from becoming oxidized or transmuted, so that it becomes possible to prevent the deterioration of the soldering performance of the land 46. If a solder derived from the solder paste including the Sn-Zn based solder material 6, provided with the aforementioned surface protective film 52, is used as the solder provided on the land 46, the solder itself may, of course, be improved in e.g. the anti-oxidation properties, although this embodiment of the present invention is not shown.

Fig.6A shows a case in which, in a structure of an electronic device, including a ball grid array 60, a semiconductor integrated circuit chip 61 is wire-bonded with a wire 64 to an interconnection pattern 63 of a substrate (interposer) 62, the chip 61 is secured to. The resulting assembly is encapsulated in molded resin 65 to form a package, and a plural number of balls 70, each of which is prepared by coating a ball-shaped Sn-Zn based solder particle 66, forming the ball grid array 60, with a surface protective film 67 embodying the present invention.

In the present embodiment, the solder particle 66 is coated from the outset with the surface protective film 67 by the above-described method, before fusing the solder particle 66 to the land 68 of a substrate 62. This allows preventing the solder particle 66 of the ball grid array 60 from being oxidized, as an example, following the fusion, to improve the soldering performance.

The above-described ball grid array 60 is loaded on a terminal part 46 (land) of the printed circuit board 45 and connected thereto with the solder paste of the present invention. Meanwhile, a solder resist provided between an upper part of the ball grid array and the land 46 is not shown.

From the above explanation, the solder material of the present embodiment, the method for the preparation thereof, and the favorable effect achieved by the solder paste, may be summarized as indicated in (1) to (9) below.
(1) The solder paste, used in the reflow soldering, may be used with advantage for the present embodiment. Since the solder paste may be prevented from becoming deteriorated, the ratio of effective use is improved to achieve cost saving.
(2) The solder material may be used in an air reflow furnace (no N₂ reflow furnace is needed). Since the pre-existing equipment is usable, the cost of equipment investment and the running cost may be diminished.
(3) Practical use of lead-free solder paste with a low melting point (190°C) may be realized with the Sn-Zn based solder (this solder may be used entirely as a substitute material for the Sn-Pb solder).
(4) The solder material and the solder paste may be manufactured easily inexpensively and has a composition of components less costly than that of a material composed essentially of Sn-Ag.
(5) Since the solder has a low melting point, soldering may be carried out in an apparatus of the same temperature distribution as that of the Sn-Pb solder, such that no new equipment cost is needed.
(6) Since no harmful metals, such as Pb, are used, contribution may be made to protection of the global environment.
(7) The solder is satisfactory in soldering performance, joining strength, quality reliability and workability. These properties of the solder are equivalent or superior to those of the Sn-Pb solder.
(8) The deficiencies of the Sn-Zn solder, such as shorter pot life, shorter shelf life, shorter repetitive printing time or susceptibility to oxidation, transmutation or generation of solder balls, may be alleviated to assure characteristics equivalent or even superior to those of the Sn-Pb based solder paste.
(9) The solder paste may be improved in stability or resistance against oxidation during reflow soldering. Moreover, the present embodiment lends itself to solution of deficiencies ascribable to the high melting point of the solder, such as severe requirement for uniform temperature distribution.

The constituent portions in the above explanation, characteristic of the present invention, will now be explained in more detail.

As the Sn alloy, used in the present invention, such Sn alloy, not containing lead, is desirable from the perspective of combating the environmental pollution. Examples of the Sn alloy include solder alloys containing Sn or Sn-Zn, added by one or more of Bi, Cu, Ag, Ge, Ni, In (indium), Sb (antimony), Al (aluminum) and Mg (magnesium). In particular, the Sn-Zn based alloys may preferably be employed because these alloys melt at temperatures close to the melting points of the conventional Sn-Pb alloys.

On the other hand, phosphates or phosphites, used for a surface protective film of the present invention, may be represented by the following formula (1): 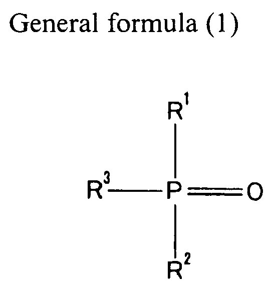
where P denotes a phosphorus atom and R¹, R² and R³ denote an alkoxyl group, a phenoxy group or derivative thereof, or hydroxyl groups. It is noted however that any of R¹, R² and R³ may also be e.g. an alkyl group or a phenyl group. Examples of the phosphates or phosphites, containing these groups, include methyl acid phosphate, ethyl acid phosphate, propyl acid phosphate, isopropyl acid phosphate, butyl acid phosphate, lauryl acid phosphate, stearyl acid phosphate, 2-ethyl hexyl acid phosphate, dedecyl acid phosphate, tetradecyl acid phosphate, hexadecyl acid phosphate, octadecyl acid phosphate, eicosyl acid phosphate, dicocyl acid phosphate, tetracocyl acod phosphate, dodecynil acid phosphate, tetradecynil acid phosphate, hexadecynil acid phosphate, octadecinyl acid phosphate, eicosinyl acid phosphate, dicocynil acid phosphate, tetracosinyl acid phosphate, isodecyl acid phosphate, phenylphosphonic acid, dimethyl phenylphosphonate, bisphenol A-bis (diphenylphosphate), 1,3-phenylenebis (dixylenyl phosphate), 1,3-phenylene bis (diphenyl phosphate), halogen containing condensed phosphate, butyl pyrophosphate, butoxy ethyl acid phosphate, oleyl acid phosphate, ethylene glycol acid phosphate, (2- hydroxyethyl) methacrylate acid phosphate, ethyl diethyl phosphonoacetate, diethyl benzyl phosphonate, diethyl allyl phosphono acetate, diethyl (p-methylbenzyl) phosphonate, 3-chloro-2- acid phosphoxy propyl methacrylate, acid phosphoxy polyoxyethylene glycol monomethacrylate, and methacroyloxyethyl acid phosphate monoethanolamine half salt.

Of these phosphates or phosphites, those in which at least one of R¹, R² and R³ is a hydroxyl group (OH), are desirable from the perspective of reactivity with the surface of the Sn, Sn alloy and Sn- Zn alloy and with the silicium (Si) containing compound. Moreover, those phosphates or phosphites in which at least one of R¹, R² and R³ is an alkoxyl group having saturated or unsaturated alkyl groups having not less than 8 and not more than 24 saturated or unsaturated alkyl groups, are desirable from the perspective of fluidity of the solder paste and blocking from moisture or oxygen in air.

On the other hand, it is sufficient that the silicium-containing compound, used for a surface protective film of the present invention, includes at least one of the alkoxy silyl group or the silanol group, and has the following general formula (2):

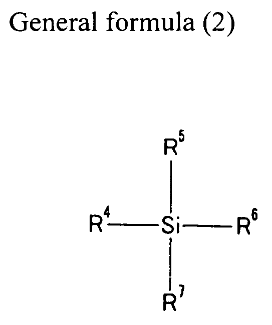

In the above general formula (2), R⁴, R⁵ R⁶ and R⁷ denote an alkokyl group, a hydroxyl group, an alkyl group, a vinyl group, an amino group containing group, an epoxy group containing group, a chloro group containing group, a methacryl group containing group, an acryl group containing group, a phenyl group, a phenetyl group, an acetoxy group, a mercapto group containing group, an OSi group, an imidazole group containing group, a dihydro imidazole group containing group or a group derived therefrom.

### Examples of the silicium containing these groups include

vinyl trimethoxy silane, vinyl triethoxy silane, N-(2-aminoethyl) 3-aminopropylmethyl dimethoxy silane, N- (2-aminoethyl)- 3-aminopropyl trimethoxy silane, 3- aminopropyl triethoxy silane, 3- aminopropyl trimethoxy silane, 3-glycidoxy propyl trimethoxy silane, 3-glycidoxy propyl methyl dimethoxy silane, 2- (3, 4- epoxy cyclohexyl) ethyl trimethoxy silane, 3-chloropropylmethyl dimethoxy silane, 3- chloropropyl trimethoxy silane, 3-methacryloxy propyl trimethoxy silane, 3-mercaptopropyl trimethoxy silane, n-butyl trimethoxy silane, n-decyl triethoxy silane, dimethyl diethoxy silane, diphenyl diethoxy silane, diphenyl methyl ethoxy silane, diphenyl silane diol, dodecylmethyl diethoxy silane, dodecyl triethoxy silane, ethyl trimethoxy silane, n-hexyl triethoxy silane, isobutyl trimethoxy silane, methyl triethoxy silane, methyl trimethoxy silane, n-octadecyl methyl diethoxy silane, n-octyl methyl diethoxy silane, phenetyl triethoxy silane, phenyl dimethyl ethoxy silane, phenyl methyl diethoxy silane, phenyl triethoxy silane, phenyl triacetoxy silane, n-propyl triethoxy silane, silicium dioxide, sodium metasilicate, sodium metasilicate cationic exchanger, sodium orthosilicate, sodium orthosilicate cationic exchanger, tetraethoxy silane, 1,1,3,3-tetraethoxy- 1,3- dimethyl disiloxane, tetrakis (ethoxyethoxy) silane, tetrakis (methoxy ethoxy ethoxy) silane, trtramethoxy silane, 1,1,3-3- tetramethyl-1,3- diethoxy disiloxane, p-tolyl trimethoxy silane, 1- (triethoxy silyl)-2-(diethoxy methyl silyl) ethane, N- (3- triethoxy silylpropy)- 4,5- (dihydro imidazole), triethyl ethoxy silane, triethyl silanol, urea propyl trimethoxy silane and an equimolar reaction product of imidazole and 3- glycidoxy propyl trimethoxy silane.

In forming a surface protective film of the present invention, the reaction between the phosphate and the silicium containing compound may be carried out in the absence of solvents or under dilution with a general-purpose solvent, such as isopropanol, ethyl acetate or toluene. The phosphate and the silicium containing compound are reacted in accordance with, for example, the following formula:

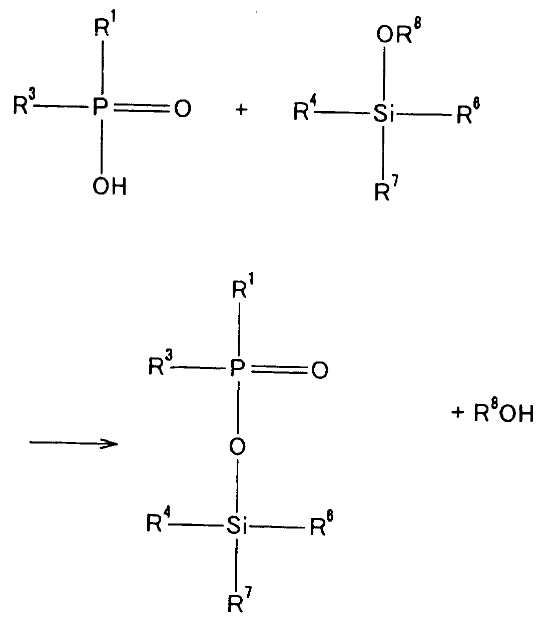

It is noted that the composition ratio of the phosphate and the silicium containing compound is such that the ratio of the alkoxy silyl group or the silanol group of the silicium containing compound to the hydroxyl group of the phosphate (ratio of the functional groups) is usually 10:1 to 1:10, preferably 5:1 to 1:5 and more preferably 1:2 to 2:1. If this reaction molar ratio is too small, the proportion of the silicium containing compound becomes excessive, such that, when the targeted ultimate surface processing film (surface protective film) is formed, a strong coating, similar to the so-called vitreous coating, is formed, thus appreciably deteriorating the wetting performance of the solder. If conversely the reaction molar ratio is excessive, the proportion of the silicium containing compound becomes too small, such that the desired hybrid effect of the phosphate and the silicium containing compound, that is, improvement in resistance against oxidation, thermal resistance or in the bonding force to metal, cannot be achieved.

The reaction temperature is usually 20°C to 100°C and preferably 60°C to 90°C. The reaction time is usually 10 minutes to five hours and preferably 30 minutes to two hours.

Meanwhile, the reaction of the phosphate and the silicium containing compound may be carried out after surface processing (deposition) of Sn or the Sn alloy and the Sn-Zn alloy. Even in case the reaction of the phosphate and the silicium containing compound is not carried out before surface processing, sufficient protection may be afforded for Sn or the Sn alloy and the Sn-Zn alloy.

In the foregoing, the phosphoric acid group in the phosphate exhibits rust-proofness on Sn or the Sn alloy and the Sn-Zn alloy by linkage to Sn or a metal which forms an alloy with Zn or Sn. The group(s) other than the phosphoric acid group in the phosphate exhibits dispersibility of solder particles in the solder paste, fluidity of the solder paste and blocking from the moisture or oxygen in air. For augmenting these properties, the phosphate preferably includes an alkoxyl group having saturated or unsaturated alkyl groups with not less than 8 and less than carbon atoms.

On the other hand, the silicium containing compound exhibits such effect that it forms a barrier film suppressing water permeation therethrough to immobilize metal ions dissolved on corrosion. Silicic acid ions, generated on dissolution of silica, are known as a film forming type anti-corrosion agent. It is said in particular that a non-soluble salt is formed between a silicic acid ion and a zinc ion to display a corrosion suppressing effect of a zinc-plated stainless steel plate. This rust-proofing technique has been put to industrial use as an organic composite zinc plated steel plate in the field of iron and steel.

Meanwhile, the silicium containing compound has been put to practical use as a flame retarder for plastics. It is said that the silicium containing compound reacts with molten high molecular materials during pyrolysis of plastics to form a cross-linked compound to suppress the total volume of volatile components. Consequently, the silicium containing compound may also be expected to eke out the low thermal resistance, that is, susceptibility to volatilization or decomposition, proper to the phosphate.

It is also well-known that the phosphate finds use as a flame retarder. Thus, as an application of an intomessent system (the system of carbide or heat-insulating layer), it has been recognized that a reaction film with a suitable cross-linking agent, such as pentaerythrytol, is efficacious for plastics, difficult to render flame retardant, such as polypropylene. It may be expected that rust-proofness and thermal resistance may be improved by formation of a cross-linked structure with th aforementioned silicium containing compound.

Meanwhile, it is well-known that the silicium containing compound is subjected to condensation on hydrolysis in the presence of a suitable acid catalyst or an alkali catalyst. More specifically, by achieving the reaction of the compound with an acidic phosphate (reaction of generating Si-O-P linkage), reaction between the silicium containing compounds (reaction of generating Si-O-Si linkage) or the reaction of the compound with Sn, Sn alloys and Sn-Zn alloys (M) (reaction of generating Si-O-M linkage) on the solder particle surface, there may be formed a hybrid protective film exhibiting high anchorage performance with respect to Sn, Sn alloys and Sn-Zn alloys.

### (Examples)

Examples of the present invention will be explained hereinbelow.

### <Example 1 >

Example 1 shows an instance of the reaction of a phosphate and a silicium containing compound.

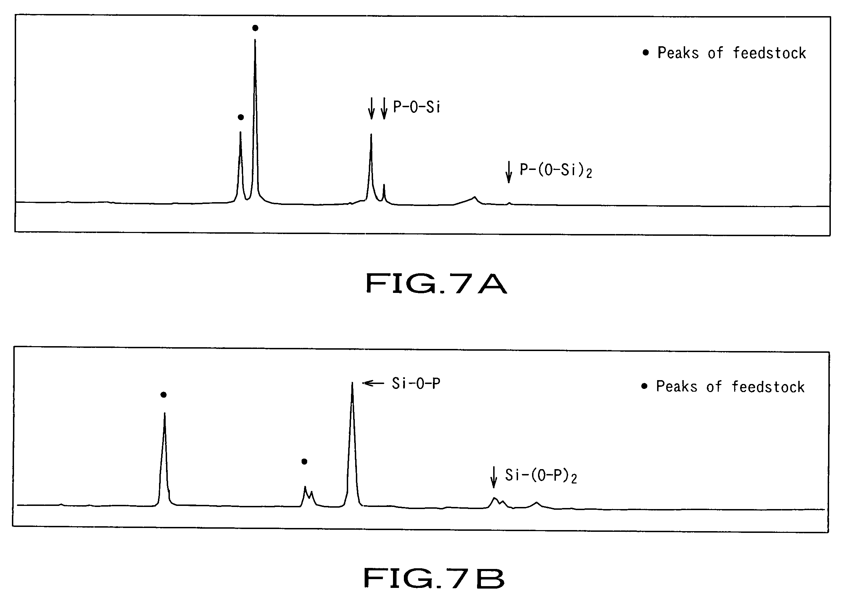

47.3 g (1 mol) of an oleyl phosphate, which is a mixture of oleyl acid phosphate with a sole OH group and oleyl acid phosphate with two OH groups, manufactured by JOHOKU KAGAKU KOGYO under a trade name of JP-518-O, with the concentration of OH groups being 1.5 OH groups per mol, and 10.4 g (0.5 mol) of tetraethoxy silane, manufactured by KANTOH KAGAKU, were charged into a 100 ml eggplant shaped flask and agitated for one hour under reflex with a magnetic stirrer at 80°C for one hour. The reaction mass was analyzed with ³¹P-NMR and ²⁹Si-NMR. It was found that a P-O-Si linkage has now been formed, as shown in Figs.7A and 7B.

### <Example 2>

In Example 2, it is demonstrated that the reaction product of a phosphate and a silicium containing compound has been improved in thermal resistance as compared to the phosphate per se as used as a feedstock.

The T-DTA analysis was carried out in an Ar atmosphere, at a temperature rise rate of 20°C per minute, for the synthesis product of Example 1 (tetraethoxy silane modified oleyl phosphate) and for oleyl phosphate. It was found that the decomposition start temperature for the former was 278°C and that for the latter was 259°C. This indicates that thermal resistance was improved by approximately 20°C in terms of the decomposition start temperature.

### <Example 3>

In Example 3, it is demonstrated that the coating of the reaction product of a phosphate and a silicium containing compound has been improved in thermal resistance as compared to the coating by the phosphate per se as used as a feedstock.

A 10 wt% solution of the synthesis product of Example 1 (tetraethoxy silane modified oleyl phosphate) and a 10 wt% solution of oleyl phosphate, each in isopropanol, were prepared. Each of these solutions was applied by a spin coating method (rpm of 1000 and time duration of 30 seconds) to a sufficiently defatted zinc plated stainless steel plate (zinc coat manufactured by SHIN-NITTETSU, non-chromate product, 60 mm by 80 mm by 0.6 mm) to form a film thereon. The coating films were each approximately 1 µm.

Each of these surface-processed zinc plated stainless steel plates was allowed to stand for 30 minutes in a drier kept at a temperature of 150°C. Meanwhile, this temperature of 150°C is a pre-heat temperature used in the reflow soldering. Before and after heat treatment, FT-IR analysis was carried out of the coating films to find the absorption peak height by the C-H vibrations in the vicinity of 2890 cm-1 to calculate the persistence of the coating film components {(peak height after heat treatment/ peak height before heat treatment) × 100}.

The zinc plated steel plates were then allowed to stand for three minutes in a drier maintained at 240°C to calculate the persistence of the coating film components in a similar manner. The thermal resistance of the coating film components was compared in terms of the persistence of the coating film components. Meanwhile, the temperature of 240°C is a temperature exceeding the reflow soldering temperature of the Sn-Zn based solder (230°C) plus an allowance (margin).

The test results are shown in Table 1, from which it is seen that heat escape is only 8% even after heat treatment of 240°C, thus indicating that the coating film has sufficient thermal resistance.

**Table 1 Test Results of Persistence of Coating Film Components**

| | Components of coating film | Persistence of Coating Film (%) | |
|---|---|---|---|
| | | 150°C×30 minutes | 240°C×3 minutes |
| Ex.3 | tetraethoxy silane modified oleyl phosphate | 100 | 92 |
| Comp. Ex.1 | oleyl phosphate | 87 | 83 |

### <Example 4>

Example 4 is relevant to the effect the ratio of the hydroxyl group of the phosphate and the alkoxysilyl or silanol group of the silicium containing compound to the hydroxyl group in the phosphate in the reaction of the phosphate and the silicium containing compound has on the force of bonding with Sn or the Sn alloy.

To each 1 mol of oleyl phosphate, containing 1.5 hydroxyl groups in one molecule, 0.125, 0.25, 0.5, 1.0 and 2.0 mols oftetraethoxy silane, having four alkoxyl groups in a molecule, were added to produce five levels of tetraethoxy silane modified oleyl phosphate, in the same way as in Example 1. A 10 wt% solution each of the five products and oleyl phosphate in isopropanol was prepared. 75 g each of the resulting solutions was charged into a 100 ml beaker and gradually added by 25 g of Sn- 8%Zn- 3%Bi powders, with a particle size the powders of 20 to 40 µm, as the solution was agitated by a magnetic stirrer. After agitation for about five minutes, the solution and the surface processed Sn- 8%Zn- 3%Bi powders were separated from each other by filtration under reduced pressure. The surface processed Sn- 8%Zn- 3%Bi powders were dried for 30 minutes in a drier maintained at 150°C.

25 g of the surface processed Sn- 8%Zn- 3%Bi powders and 75 g of isopropanol were charged into a 100 ml beaker and allowed to stand for 30 minutes. The solution and the surface processed Sn- 8%Zn- 3%Bi powders were separated from each other by filtration under reduced pressure, followed by drying for 30 minutes in a drier maintained at 60°C.

For each of the Sn- 8%Zn- 3%Bi powders, the quantity of carbon before and after immersion in isopropanol was quantized to calculate the persistence of the coating film components {(carbon quantity after immersion in isopropanol / carbon quantity before immersion in isopropanol) × 100}. The results are shown in Table 2.

**Table 2 Persistence of Coating Film Components**

| | Ratio of functional groups | Persistence of coating film components (%) |
|---|---|---|
| Ex.4-1 | 1: 0.33 | 20 |
| Ex.4-2 | 1: 0.67 | 30 |
| Ex.4-3 | 1: 1.33 | 40 |
| Ex.4-4 | 1: 2.67 | 35 |
| Ex.4-5 | 1: 5.33 | 30 |
| Comp. Ex.1 | oleyl phosphate | 18 |

### <Example 5>

It is demonstrated in Example 5 that the solder powder is suppressed from oxidation or transmutation by surface processing, resulting in improved repetitive printability or in improved shelf life.

A flux for a solder paste, composed of 30 parts by weight (abbreviated below to parts) of polymerized rosin, 30 parts of hydrogenated rosin, 30 parts of a solvent (hexylene glycol, hexyl glycol, 2-ethylhexyl diglycol and terpineol), 5 parts of activating agents (C1 to C30 organic acids and amine hydrobromate) and 5 parts of thxo agent (hardened castor oil), was prepared.

Apart from the above flux, Sn- 8%Zn- 3%Bi powders, with the particle size of 20 to 40 µm, surface-processed with tetraethoxy silane modified oleyl phosphate, were prepared. To 88 parts of the surface-processed powders were added 12 parts of the above flux and the resulting mixture was thoroughly kneaded in a blender to prepare a solder paste. Another solder paste was also prepared in similar manner from powders not surface-processed as described above.

These solder pastes were evaluated as to repetitive printability and shelf life. It was found that the time for repetitive printability and the shelf life of the solder paste employing surface-processed powders were 12 hours and 24 hours, respectively, while those of the solder paste prepared from powders not surface-processed as described above were 4 hours and 8 hours, respectively.

### <Example 6>

In Example 6, there is shown a case wherein, if, in the reaction between a phosphate and a silicium containing compound, the ratio of the hydroxyl groups in the phosphate and the alkoxy silyl group or the silanol group (ratio of the functional groups) is too small, solder wettability is deteriorated.

To one mol of an oleyl phosphate, containing 1.5 hydroxyl groups in one molecule, four mols of tetraethoxy silane, containing four alkoxyl groups in one molecule, were added to synthesize tetraethoxy silane modified oleyl phosphate, with the function group ratio of 1: 10.67, by the same method as in Example 1. As in Example 4, Sn- 8%Zn- 3%Bi powders, surface-processed with tetraethoxy silane modified oleyl phosphate, were prepared. To 88 parts of the surface-processed powders were added 12 parts of the flux of Example 5 and mixed thoroughly to prepare a solder paste. Another solder paste was prepared in similar manner, using non- surface-processed powders.

These solder pastes were put to a test for wetting efficacy and for dewetting in accordance with JIS Z3284 annexed papers 10. The result indicated that the solder was difficult to wet (class 4).

### <Example 7>

In Example 7, it is demonstrated that the solder powers were suppressed from oxidation by surface processing.

As in Example 4, Sn- 8%Zn- 3%Bi powders, surface-processed with tetraethoxy silane modified oleyl phosphate, were prepared. To 88 parts of the surface-processed powders were added 12 parts of the flux of Example 5 and mixed thoroughly to prepare a solder paste. Another solder paste was prepared in similar manner, using non- surface-processed powders.

These solder pastes were put to a solder ball test in accordance with JIS Z3284 annexed papers 11. The results indicated that two solder balls were produced in case of the solder paste employing the surface-processed powders, while six solder balls were produced in case of the solder paste employing the non-surface-processed powders. It is noted that the smaller the number of the solder balls, the more strongly the oxidation is suppressed.

### <Example 8>

In Example 8, it is demonstrated that the pot life (preservation stability) of the paste employing the surface-processed solder powders has been improved significantly as compared to that of the paste employing the non-surface-processed solder powders.

The solder paste, shown in Example 7, was accommodated in a hermetically sealed vessel, and allowed to stand in a constant temperature tank maintained at 25°C. The changes in viscosity of this solder paste were measured with lapse of time by a rheometer and the number of days until the viscosity rose by 500P from the initial value was counted. It was found that the number of days for the solder paste employing the surface-processed powders was 15, while that for the solder paste employing the non-surface-processed powders was 3.

### <Example 9>

In Example 9, it is demonstrated that the solder obtained from a surface-processed Sn-Zn alloy material has been improved significantly in wettability as compared to the solder obtained from a non- surface-processed Sn-Zn alloy material. It is also demonstrated that solder wettability has been improved as compared to the case of using phosphate alone as a feedstock of the surface processing agent.

Each of 15 different acidic phosphates, shown in Table 3, is reacted with tetraethoxy silane by a method and with a molar ratio which are the same as those of Example 1.15 different 1 wt% isopropanol solutions, containing these 15 reaction products as effective components, were prepared.

On the other hand, a phosphor bronze hoop material (18 mm × 100 mm) was pre-processed with alkali electrolytic defatting (ambient temperature, 15A/dm², processing time being approximately 30 seconds), washing with water, immersing in acid (with 10% sulfuric acid, ambient temperature, for five seconds), water washing, chemical polishing (immersing for one minute in CPB-40 at ambient temperature), washing with water, immersing in acid (with 10% sulfuric acid, ambient temperature, for five seconds) and washing with water, in this order.

This substrate was plated with an Sn- 10%Zn alloy to a thickness of approximately 5µm (plating bath manufactured by NIKKO METAL PLATING KK; plating conditions: cathode current density, 3A/dm², temperature, 35°C, pH 4.0; liquid flowing and cathode vibrating plating).

The substrate, plated with the Sn- 10%Zn alloy, was immersed for one minute in the aforementioned solution for surface processing. The substrate was then dried with a drier to a test substrate which was then used in the following test for evaluation of solder wettability.

Solder wettability of the substrate with lead-free solder (tin: silver: copper: = 96.5: 3: 0.5, bath temperature 245°C) directly following post-processing and following pressure cooker test (PCT processing) (allowing the substrate to stand for 16 hours in a hermetically sealed kiln maintained at a temperature of 105°C and RH of 100%) was evaluated by measuring the zero cross time with the meniscographic method (JIS C 0050). As the flux, NA-200 (IPA solution of rosin manufactured by TAMURA KAKEN) was used. The test results are shown in the following Table 3.

**Table 3 Results of Evaluation of Solder Wettability**

| | surface processing | directly after post-processing | directly after PCT processing |
|---|---|---|---|
| Ex.9-1 | reaction product of oleyl phosphate and tetraethoxy silane | Ⓞ | Ⓞ |
| Ex.9-2 | reaction product of dodecyl phosphate and tetraethoxy silane | Ⓞ | Ⓞ |
| Ex.9-3 | reaction product of tetradecyl phosphate and tetraethoxy silane | Ⓞ | Ⓞ |
| Ex.9-4 | reaction product of hexadecyl phosphate and tetraethoxy silane | Ⓞ | Ⓞ |
| Ex.9-5 | reaction product of octadecyl phosphate and tetraethoxy silane | Ⓞ | Ⓞ |
| Ex.9-6 | reaction product of eicosyl phosphate and tetraethoxy silane | Ⓞ | Ⓞ |
| Ex.9-7 | reaction product of dicosyl phosphate and tetraethoxy silane | Ⓞ | Ⓞ |
| Ex.9-8 | reaction product of tetracosyl phosphate and tetraethoxy silane | Ⓞ | Ⓞ |
| Ex.9-9 | reaction product of dodecinyl phosphate and tetraethoxy silane | Ⓞ | Ⓞ |
| Ex.9-10 | reaction product of tetradecinyl phosphate and tetraethoxy silane | Ⓞ | Ⓞ |
| Ex.9-11 | reaction product of hexadecinyl phosphate and tetraethoxy silane | Ⓞ | Ⓞ |
| Ex.9-12 | reaction product of octadecinyl phosphate and tetraethoxy silane | Ⓞ | Ⓞ |
| Ex.9-13 | reaction product of eicosinyl phosphate and tetraethoxy silane | Ⓞ | Ⓞ |
| Ex.9-14 | reaction product of dicosinyl phosphate and tetraethoxy silane | Ⓞ | Ⓞ |
| Ex.9-15 | reaction product of tetracosinyl phosphate and tetraethoxy silane | Ⓞ | Ⓞ |
| Comp.Ex.2 | octadecinyl phosphate | Ⓞ | Ⓞ |
| Comp.Ex.3 | Not processed | Ⓞ | × |

| | | | |
|---|---|---|---|
| Ⓞ = zero-crossing time of not less than 0 sec and less than 1 sec | | | |
| ○ = zero-crossing time of not less than 1 sec and less than 3 sec | | | |
| X = zero-crossing time of not less than 5 seconds | | | |

It may be seen from above that the surface processing by the Examples has outstanding efficacy on improving solder wettability of the Sn-Zn alloy material. It has been confirmed that this surface processing has the favorable effect of improving solder wettability (the effect of suppressing the oxidation) on other Sn alloy materials.

### <Example 10>

In Example 10, it is demonstrated that whiskers are produced in an appreciably lesser quantity in case an Sn alloy material is surface-processed than in case an Sn- Zn alloy material is not so processed.

As in Example 9, a substrate plated with an Sn- 10%Zn alloy, surface-processed with tetraethoxy silane modified oleyl phosphate, and another substrate plated with a non-surface-processed Sn- 10%Zn alloy, were allowed to stand for 24 hours in a constant temperature constant humidity environment of a temperature of 85°C and the humidity of 85%. After the substrates were dried sufficiently, the substrate surfaces were visually checked over a scanning electronic microscope (SEM) under 3000 to 10000 magnifications. It was seen that many whiskers were observed on the substrate plated with unprocessed alloy, whilst no whiskers were observed whatsoever on the substrate plated with a processed alloy.

### <Example 11>

In Example 11, it is demonstrated that solder wettability of surface-processed Sn alloy solder balls has been significantly improved over that of non-surface-processed Sn alloy solder balls.

A Sn- 9%Zn ball, surface-processed with tetraethoxy silane modified oleyl phosphate (300 µm in diameter) was prepared by surface processing similar to that in Example 4.

A flux material was printed on a copper terminal part between solder resists on a main body part of a ball grid array (BGA). The Sn- 9%Zn solder ball was then placed on the ball grid array and reflow was then carried out in an open air atmosphere at a peak temperature of 220°C.

The joining performance of the Sn- 9%Zn ball to the BGA substrate was then observed. It was seen that no joining failure was observed with the BGA substrate employing the surface-processed Sn- 9%Zn ball, whilst 1% joining failure was noticed with the BGA substrate employing the non-surface-processed Sn- 9%Zn ball.

### <Example 12>

In Example 12, it is demonstrated that the solder obtained on surface-processing a Sn material has been significantly improved in solder wettability as compared to the non- surface-processed material. It is also demonstrated that the solder obtained on surface-processing the Sn material has also been improved as compared to the solder plated only with the phosphate used as feedstock.

A 1 wt% solution of the synthesis product of Example 1 (tetraethoxy silane modified oleylkphosphate) in isopropanol and another 1 wt% solution of oleyl phosphate in isopropanol were prepared. On the other hand, a phosphor bronze hoop material (18 mm×100 mm) was pre-processed with alkali electrolytic defatting (ambient temperature, 15A/dm², processing time being approximately 30 seconds), washing with water, immersing in acid (with 10% sulfuric acid, ambient temperature, for five seconds), water washing, chemical polishing (immersing for one minute in CPB-40 at ambient temperature), washing with water, immersing in acid (with 10% sulfuric acid, ambient temperature, for five seconds) and washing with water, in this order.

This substrate was then subjected to electrical Sn plating to a film thickness of approximately 10 µm (plating bath manufactured by NIKKO METAL PLATING KK under the trade name of SP- 1HLF: cathode current density, 3A/dm².

These Sn-plated substrates were then immersed for one minute in the aforementioned solution for surface processing. The substrates, as test substrates, were then put to the following test for evaluating solder wettability.

Solder wettability of the substrate with lead-free solder (tin: silver: copper: = 96.5: 3: 0.5, bath temperature 245°C) directly following post-processing and following pressure cooker test (PCT processing) (allowing the substrate to stand for 16 hours in a hermetically sealed kiln maintained at a temperature of 105°C and RH of 100%) was evaluated by measuring the zero cross time with the meniscographic method as in Example 8. As the flux, NA-200 (IPA solution of rosin manufactured by TAMURA KAKEN) was used. The test results are shown in the following Table 4, along with those of Comparative Examples.

**Table 4 Results of Evaluation of Wettability of Solder**

| | surface processing | directly after post Processing | directly after PCT processing |
|---|---|---|---|
| Ex.12 | processing with tetraethoxy silane modified oleyl phosphate | Ⓞ | Ⓞ |
| Comp. Wx.4 | not processed | Ⓞ | × |
| Comp. Ex.5 | processing with oleyl phosphate | Ⓞ | ○ |

| | | | |
|---|---|---|---|
| Ⓞ = zero crossing time, not less than 0 sec and less than 1 sec | | | |
| ○ = zero crossing time, not less than 1 sec and less than 3 sec | | | |
| × = zero crossing time, not less than 5 sec | | | |

### <Example 13>

In Example 13, it is demonstrated that the quantity of the whiskers produced on a surface processed Sn material is decreased significantly as compared to that on a Sn material whose surface is not surface-processed.

As in Example 12, a substrate plated with Sn was surface-processed with tetraethoxy silane modified oleyl phosphate. The substrate surface-processed and plated with Sn and a Sn plated substrate not surface processed were allowed to stand for 24 hours in a constant temperature constant humidity environment of a temperature of 85°C and the humidity of 85%. After the substrates were dried sufficiently, the substrate surfaces were visually checked over a scanning electronic microscope (SEM). It was seen that many whiskers were observed on the substrate not surface-processed, whilst no whiskers were observed whatsoever on the surface-processed substrate.

The present invention is not limited to the above-described embodiments explained with reference to the drawings and, as may be apparent to those skilled in the art, a large variety of changes, substitutions or equivalents may be attempted without departing from the scope of the invention as set forth in the claims.

For example, in the Sn-Zn based solder composition, one or more of Cu, Ge, Ni, Mg, In, Al or Sb, to say nothing of Bi, may be used as a component to be added to Sn-Zn. As for the solder paste, the composition ratio of the Sn-Zn based solder particles, provided with a surface protective film, or the types of the other components, may be selected arbitrarily.

The present invention may be combined with methods for improving anti-oxidation properties, anti-corrosion properties or anti-transmutation properties by a method of improving the alloy composition or a method of forming a protective film with a flux, for displaying synergistic effects. This combination is particularly effective in case defects such as pinholes are present on a surface protective film of the present invention by some reason or other.

The Sn or Sn-Zn based coating material, such as plating material, solder material or the solder paste, usable in the present invention, may naturally be used for the preparation of SMD, IMD or in printed circuit boards for electrical equipment, having mounted the SMD or the IMD thereon, and may also be used as soldering material or as surface processing material for various other fields. The coating material, solder material or the solder paste, usable in the present invention, is free of heavy metals, such as lead, chromium or cadmium, harmful to a human body, and hence may be used as a material for preparing steel plates or as a material for preparing cans for canned foods or for beverages.

### Industrial Utilizability

According to the present invention, described above, in which a surface protective film of a phosphate and a silicium containing compound is formed on the surface of a coating material, such as a plating material, or a solder particle, the coating material, such as plating material, or the solder particle, may be blocked by the surface protective film from corrosive components, inclusive of moisture or oxygen in air, chlorine or sulfur, inclusive of acidic rain, or from components of the flux used, as a result of which the coating material, such as plating material, or the solder particle, may be safeguarded against corrosion, transmutation or oxidation.

It is moreover possible to improve repetitive printability in reflow soldering, time duration of preservation (pot life) of the solder paste, and time duration of retention of the adhesive force following the screen printing (shelf life), so that the adhesive force for electronic parts mounted may be retained for a required time period, whereby the rate of effective use of the Sn-Zn based solder paste may be improved. In addition, in the processing in a reflow furnace, it is possible to prevent oxidation of a matrix material (electrodes of component parts or lands of printed circuit boards) or solder particles to eliminate insufficient wetting or generation of solder balls (oxidized micro-sized independent particles) to enable the use of a general-purpose device, such as air reflow furnace. The result is that the features of a Sn-Zn based solder, as a lead-free solder, that is low melting and may take the place of a Sn-Pb solder, may be effectively displayed to provide for soldering with high insulation reliability (through use of a surface processing material difficult to isolate and ionize or through suppression of generation of solder balls).

Moreover, a protective film is formed on the surface of a solder particle of e.g. a Sn-Zn based alloy, by surface processing in a non-aqueous solution, that is, solution in an organic solvent, and hence there is no risk of the Sn-Zn based alloy contacting with moisture or oxygen in the course of manufacture of the solder material. Thus, the Sn-Zn based alloy has no opportunity to be transmuted by being reacted with the moisture or oxygen, with the result that the targeted solder material may be acquired reliably in stability.

Since the inventive method forms a protective film by surface processing, not only the surface of a solder material, such as a solder ball (for e.g. BGA or CSP) or a solder particle (for a solder paste) but also the surface of a Sn or Sn alloy applied as a surface processing agent (such as by electrical plating or melt plating) on the surface of a metal material (iron, stainless steel plate, copper or alloys thereof), such as an electrode or a terminal of an SMD or an IMD, a casing of an electronic device or an interconnection pattern of a printed circuit board, may be coated by a method of the present invention, in distinction from the method of forming a protective film by e.g. a flux, with the result that a stable metal material (base material) may be obtained which is superior in corrosion resistance, resistance against oxidation or transmutation, or in solderability.

Furthermore, since the surface protective film of the present invention is composed of at least one ester selected from the group of a phosphate, phosphate and derivative thereof, a silicium containing compound, and a reaction product of the ester and the silicium containing compound, it is sufficient to contact the surface processing agent in a state of a solution with the surface of the tin or tin alloy material and to dry the agent to form a film thereon readily at low cost without requiring any special conditions. Moreover, since the surface protective film may be fixed on the surface sufficiently and homogeneously, evenness of film thickness may be improved extremely readily, with the result that the aforementioned surface protective operation may be displayed sufficiently.

## Claims

1. A surface processing agent for tin or a tin alloy material essentially composed of a substance selected from the group consisting of at least one ester selected from the group consisting of a phosphate, a phosphite and derivative thereof, a silicium containing compound, and a reaction product and/or a mixture of said ester and said silicium containing compound.

2. The surface processing agent according to claim 1 wherein said substance is diluted with an organic solvent.

3. The surface processing agent according to claim 1 wherein the ratio of said ester and said silicium containing compound is 1: 10 to 10: 1 in terms of a molar ratio.

4. The surface processing agent according to claim 1 wherein said phosphate, phosphite and the derivative thereof include at least one saturated or unsaturated alkyl group and/or a hydroxyl group.

5. The surface processing agent according to claim 1 wherein said silicium containing compound includes at least one alkoxy silyl group and/or a silanol group.

6. The surface processing agent according to claim 1, used for surface processing for a tin alloy material or a tin-zinc alloy material containing at least one metal selected from the group consisting of tin or zinc, by itself, zinc, bismuth, copper, silver, antimony, indium, aluminum, magnesium, germanium and nickel.

7. A method for surface processing tin or a tin alloy material comprising coating the surface of tin or the tin alloy material with a solution obtained on diluting at least one ester selected from the group consisting of a phosphate, a phosphite and derivative thereof, a silicium containing compound, and a reaction product and/or a mixture of said ester and said silicium containing compound, and drying the resulting product.

8. A method for surface processing tin or a tin alloy material comprising coating the surface of tin or a tin alloy material with a solution obtained on diluting at least one ester selected from the group consisting of a phosphate, a phosphite and derivative thereof, with an organic solvent, drying the resulting product, coating the resulting dried film with a solution obtained on diluting the silicium containing compound with an organic solvent, and drying the resulting product.

9. A method for surface processing tin or a tin alloy material comprising coating the surface of tin or the tin alloy material with a solution obtained on diluting a silicium containing compound with an organic solvent, drying the resulting product, depositing a solution obtained on diluting at least one ester selected from the group consisting of a phosphate, a phosphite and derivative thereof, on the resulting dried film, with an organic solvent, and drying the resulting product.

10. The surface processing method according to claim 7 wherein the ratio of said ester and said silicium containing compound is 1: 10 to 10: 1 in terms of a molar ratio.

11. The surface processing method according to any one of claims 7 to 9 wherein said phosphate, phosphite or the derivative thereof including at least one saturated or unsaturated alkyl group and/or a hydroxyl group is used.

12. The surface processing method according to any one of claims 7 to 9 wherein said silicium containing compound includes at least one alkoxy silyl group and/or a silanol group.

13. The surface processing method according to any one of claims 7 to 9 wherein said tin alloy material or the tin-zinc alloy material containing at least one metal selected from the group consisting of tin or zinc, by itself, zinc, bismuth, copper, silver, antimony, indium, aluminum, magnesium, germanium and nickel is surface-processed.

14. Tin, a zinc material, a tin alloy material or a tin-zinc alloy material having a surface protective film composed of at least one selected from the group consisting of the ester, silicium containing compound and the reaction product thereof as set forth in any one of claims 1 to 5.

15. Tin, zinc material, tin alloy material or the tin-zinc alloy material according to claim 14 wherein said surface protective film, formed thereon, is a single-layer film, composed of said ester, silicium containing compound and the reaction product thereof.

16. Tin, zinc material, tin alloy material or the tin-zinc alloy material according to claim 14 wherein said surface protective film is formed as two or more layers each being a thin film of said ester, a thin film of said silicium containing compound or a thin film of said reaction product corresponding to a combination thereof.

17. Tin, zinc material, tin alloy material or the tin-zinc alloy material according to claim 16 wherein one or more of said thin film is formed in contact with the surface of tin, zinc material, tin alloy material or the tin-zinc alloy material.

18. Tin, zinc material, tin alloy material or the tin-zinc alloy material according to claim 14 composed of a tin alloy material or a tin-zinc alloy material containing at least one metal selected from the group consisting of tin or zinc, by itself, zinc, bismuth, copper, silver, antimony, indium, aluminum, magnesium, germanium and nickel.

19. A tin alloy based solder material wherein a surface protective film composed of at least one selected from the group consisting of the ester, silicium containing compound and the reaction product thereof as set forth in any one of claims 1 to 5 is formed on the surface of a tin alloy based solder particle.

20. The tin alloy based solder material according to claim 19 wherein said surface protective as a single-layer film, composed of said ester, said silicium containing compound or the reaction product thereof, is formed.

21. The tin alloy based solder material according to claim 19 wherein said surface protective film is formed as two or more layers each being a thin film composed of said ester or a thin film composed of said silicium containing compound.

22. The tin alloy based solder material according to claim 21 wherein one or more of said thin films is formed in contact with the surface of said tin alloy based solder particle.

23. The tin alloy based solder material according to claim 19 wherein said tin alloy based solder particle is composed of a tin alloy material or a tin-zinc alloy material containing at least one metal selected from the group consisting of zinc, bismuth, copper, silver, antimony, indium, aluminum, magnesium, germanium and nickel.

24. The tin alloy based solder material according to claim 19 in the form of a solder particle or a solder ball.

25. A method for producing a tin alloy based solder material comprising coating the surface of a tin alloy based solder particle with a solution obtained on diluting at least one ester selected from the group consisting of a phosphate, a phosphite and a derivative thereof, and a reaction product and/or a mixture thereof with a silicium containing compound, with an organic solvent, and drying the resulting product.

26. A method for producing a tin alloy based solder material comprising coating the surface of a tin alloy based solder particle with a solution obtained on diluting at least one ester selected from the group consisting of a phosphate, a phosphite and a derivative thereof, with an organic solvent, drying the resulting product, depositing a solution, obtained on diluting a silicium containing compound with an organic solvent, on the resulting dried film, and drying the resulting product.

27. A method for producing a tin alloy based solder material comprising coating the surface of a tin alloy based solder particle with a solution obtained on diluting a silicium containing compound with an organic solvent, drying the resulting product, depositing a solution obtained on diluting at least one ester selected from the group consisting of a phosphate, a phosphite and a derivative thereof, with an organic solvent, on the resulting dried film, and drying the resulting product.

28. The method according to claim 25 wherein the ratio of an alkoxy silyl group or the silanol group contained in said silicium containing compound to the hydroxyl group contained in said ester is set to 10: 1 to 1: 10.

29. The method according to any one of claims 25 to 27 wherein said phosphate, said phosphite and the derivative, containing at least one saturated and/or unsaturated alkyl group and/or a hydroxyl group, is used.

30. The method according to any one of claims 25 to 27 wherein said silicium containing compound containing at least one alkoxy silyl group and/or a silanol group is used.

31. The method according to any one of claims 25 to 27 wherein a solder particle of said tin alloy based or tin- zinc alloy based solder particle, containing at least one metal selected from the group consisting of zinc, bismuth, copper, silver, antimony, indium, aluminum, magnesium, germanium and nickel is surface-processed.

32. A solder paste containing the solder particle as set forth in claim 24.

33. The solder paste according to claim 32 including the surface protective film as set forth in any one of claims 20 to 22 on the surface of said solder particle.

34. The solder paste according to claim 32 wherein said solder particle is formed of a tin alloy based solder material as set forth in claim 23.

35. The solder paste according to claim 32 further comprising, in addition to said solder particle, a flux composed of polymerized rosin, hydrogenated rosin, a solvent, an activating agent and a thixo agent.

36. An electronic device wherein a connection terminal part or an electrode is formed of tin, zinc, a tin alloy material or a tin-zinc alloy material as set forth in any one of claims 14 to 18.

37. An electronic device wherein the solder ball as set forth in claim 24 is used as an electrical connecting material for a device and a terminal.

38. The electronic device according to claim 37 wherein said solder ball is formed of tin, zinc, a tin alloy material or a tin-zinc alloy material as set forth in any one of claims 15 to 18.

39. The electronic device according to claim 37 comprising a ball grid array formed by a plurality of said solder balls (inclusive of CSP).

40. A printed circuit board wherein an interconnect pattern and a connection terminal part thereof are formed of tin, zinc, a tin alloy material or a tin-zinc alloy material as set forth in any one of claims 14 to 18.

41. A mount structure of an electronic device wherein the electronic device as set forth in claim 36 is connected to a printed circuit board.

42. A mount structure of an electronic device wherein the electronic device as set forth in claim 37 is used.

43. The mount structure according to claim 42 wherein the solder ball as set forth in claim 38 is used as a terminal for the electronic device for interconnecting the electronic device and the printed circuit board.

44. The mount structure according to claim 42 wherein said solder ball forms a ball grid array.

45. A mount structure of an electronic device wherein an electronic device is connected to a printed circuit board as set forth in claim 40.

46. A mount structure of an electronic device wherein the solder paste as set forth in any one of claims 32 to 35 is used as an electrical connecting material.

47. The mount structure according to claim 46 wherein said solder paste is used for interconnecting the electronic device to the printed circuit board or for interconnecting a plurality of said electronic devices.
